# EUROPÄISCHE PATENTANMELDUNG

(11) **EP 4 607 745 A1**
(43) Veröffentlichungstag der Anmeldung: **27.08.2025**
(21) Anmeldenummer: 24158878.9
(22) Anmeldetag: 21.02.2024
(51) Int. Cl.: H02J 7/00, G01R 31/382, G01R 31/392

(54) **REGELUNG EINES HPC-VERFAHRENS SOWIE HPC-VERFAHREN FÜR EINE BATTERIEZELLE**

(71) Anmelder: Siemens Aktiengesellschaft, 80333 München (DE)
(72) Erfinder: Fischer, Michael, 91320 Ebermannstadt (DE); Arzberger, Arno, 96135 Stegaurach (DE); Katzer, Felix, 90763 Fürth (DE); Radinger, Hannes, 90459 Nürnberg (DE); Winterstein, Heiko, 91325 Adelsdorf (DE)
(74) Vertreter: Siemens Patent Attorneys

(57) **Zusammenfassung**

Es wird ein Verfahren zur Regelung eines HPC-Verfahrens für eine Batteriezelle vorgeschlagen, beim dem die Batteriezelle zwischen zwei regelbaren Spannungswerten *V*₁, *V*₂ zyklisiert wird, wobei für die Regelung zwei Sollwerte der Ruhespannung *V*ₘᵢₙ, *V*ₘₐₓ der Batteriezelle festgelegt sind. Das Verfahren ist wenigstens durch folgende Schritte gekennzeichnet:
- (S1) Abschalten des Stromes bei einem Erreichen des jeweiligen Spannungswertes *V*₁, *V*₂;
- (S2) Ermitteln der jeweiligen Ruhespannung basierend auf einem durch das Abschalten des Stromes induzierten jeweiligen Abklingverhalten (41) der Spannung; und
- (S3) Regeln der Spannungswerte *V*₁, *V*₂*,* wobei der jeweilige Betrag des Spannungsunterschieds *ΔV*₁, *ΔV*₂ (42) zwischen der jeweiligen ermittelten Ruhespannung und ihrem zugehörigen Sollwert *V*ₘᵢₙ, *V*ₘₐₓ als Regeldifferenz verwendet wird.

Weiterhin betrifft die Erfindung HPC-Verfahren für eine Batteriezelle.

## Beschreibung

Die Erfindung betrifft ein Verfahren gemäß dem Oberbegriff des Patentanspruches 1 sowie ein Verfahren gemäß dem Oberbegriff des Patentanspruches 9.

Batteriezellen können mittels verschiedener Kenngrößen charakterisiert werden. Allerdings weisen die genannten Kenngrößen je nach Zelltyp, Betriebsbedingungen und Produktionsqualität deutliche Unterschiede auf. Wichtige Kenngrößen sind insbesondere die Lebensdauer sowie die Selbstentladungsrate einer Batteriezelle.

Die Lebensdauer einer Batteriezelle kennzeichnet die Rate des Verlusts an nutzbarer Kapazität über die Zeit und/oder über die Betriebszyklen hinweg.

Die Selbstentladungsrate einer Batteriezelle kennzeichnet die Rate des Verlusts der mittels der Zelle gespeicherten Energie, ohne dass diese Energie extern genutzt wurde.

Typischerweise führen die Lebensdauer und die Selbstentladungsrate erst über vergleichsweise großen Zeitskalen zu messbaren Änderungen. Für praktische Untersuchungen und Bewertungen von Batteriezellen ist es hingegen wichtig, die genannten Kenngrößen innerhalb eines möglichst kurzen Zeitraums zu ermitteln.

Zur Reduzierung der Testdauer von Lebensdauer- und Selbstentladungsmessungen wird im Stand der Technik auf beschleunigte Tests zurückgegriffen, die bei höheren Temperaturen und gegebenenfalls höheren Stromstärken durchgeführt werden. Dadurch kann eine beschleunigte Alterung und Selbstentladungen der Batteriezelle provoziert werden. Allerdings stellen diese Testbedingungen nicht das Verhalten der Batteriezelle unter typischen und damit relevanten Betriebsbedingungen dar.

Weitere bekannte Verfahren zur Ermittlung der genannten Kenngrößen verwenden eine höhere Genauigkeit, um so kleinere Änderungen bereits auf kurzen Zeitskalen zu erfassen. Ein solches Verfahren ist die High Precision Coulometry (HPC-Verfahren), mittels welchem der Batteriezelle entnommene und/oder ihr zugeführte Ladungsmengen sehr genau erfasst werden können.

Das HPC-Verfahren macht sich zu Nutze, dass der Ladezustand einer Batteriezelle (englisch: State of Charge; SOC) im Zusammenhang mit der Ruhespannung der Batteriezelle steht. Beim HPC-Verfahren wird zwischen zwei definierten Ladezuständen zyklisiert, wobei die definierten Ladezustände mit entsprechenden festgelegten Ruhespannungen zusammenhängen. Das HPC-Verfahren misst die Ladungsmengen während der einzelnen Ladezyklen und Entladezyklen. Dadurch können die Coulombic Efficiency (CE) und/oder geringe Kapazitätsverluste innerhalb weniger Zyklen erfasst werden. Hieraus ergeben sich schließlich Aussagen über die Selbstentladungsrate und die Lebensdauer der Batteriezelle.

Nachteilig an bekannten HPC-Verfahren ist, dass aufgrund der bei der Messung verwendeten Stromstärken es zu kinetischen Effekten innerhalb der Batteriezelle kommen kann. Dadurch ist die an der Batteriezelle erfasste Spannung verschieden von ihrer Ruhespannung. Der genannte Unterschied zwischen der erfassten Spannung und der Ruhespannung der Batteriezelle wird als Überspannung bezeichnet. Die Überspannung kann sich innerhalb des HPC-Verfahrens von Zyklus zu Zyklus ändern, sodass die Voraussetzung des HPC-Verfahrens verletzt ist, dass die Testzyklen zwischen gleichbleibenden Ladezuständen durchgeführt werden.

Der vorliegenden Erfindung liegt die Aufgabe zugrunde, ein verbessertes HPC-Verfahren, insbesondere durch eine verbesserte Regelung eines HPC-Verfahrens, bereitzustellen.

Die Aufgabe wird durch ein Verfahren mit den Merkmalen des unabhängigen Patentanspruches 1 sowie durch ein Verfahren mit den Merkmalen des unabhängigen Patentanspruches 9 gelöst. In den abhängigen Patentansprüchen sind vorteilhafte Ausgestaltungen und Weiterbildungen der Erfindung angegeben.

Bei dem erfindungsgemäßen Verfahren zur Regelung eines HPC-Verfahrens für eine Batteriezelle wird die Batteriezelle zwischen zwei regelbaren Spannungswerten *V*₁, *V*₂ zyklisiert, wobei für die Regelung zwei Sollwerte der Ruhespannung *V*ₘᵢₙ, *V*ₘₐₓ der Batteriezelle festgelegt sind. Das erfindungsgemäße Verfahren ist gekennzeichnet durch folgende Schritte:
- Abschalten des Stromes bei einem Erreichen des jeweiligen Spannungswertes *V*₁, *V*₂;
- Ermitteln der jeweiligen Ruhespannung basierend auf einem durch das Abschalten des Stromes induzierten jeweiligen Abklingverhalten der Spannung; und
- Regeln der Spannungswerte *V*₁, *V*₂*,* wobei der jeweilige Betrag des Spannungsunterschieds Δ*V*₁*,* Δ*V*₂ zwischen der jeweiligen ermittelten Ruhespannung und ihrem zugehörigen Sollwert *V*ₘᵢₙ, *V*ₘₐₓ als Regeldifferenz verwendet wird.

Ohne Einschränkung des Schutzumfanges wird im Weiteren *V*₁ > *V*₂ angenommen. Mit anderen Worten erfolgt gemäß dem Verfahren eine Zyklisierung der Spannung zwischen einem oberen Spannungswert *V*₁ und einem unteren Spannungswert *V*₂. Hierbei sind die Spannungswerte *V*₁, *V*₂ regelbar, das heißt, dass sich diese aufgrund der Regelung zeitlich ändern können.

Weiterhin sind für die Batteriezelle zwei Sollwerte bezüglich ihrer Ruhespannung *V*ₘᵢₙ, *V*ₘₐₓ festgelegt. Die genannten Ruhespannungen können für das Verfahren bereitgestellt werden. Die festgelegten Ruhespannungen *V*ₘᵢₙ, *V*ₘₐₓ bilden Sollwerte der Regelung aus. Mit anderen Worten wird durch die erfindungsgemäße Regelung sichergestellt, dass die aus dem Abklingverhalten ermittelten Ruhespannung auf die festgelegten Ruhespannungen *V*ₘᵢₙ, *V*ₘₐₓ eingeregelt werden.

In einem ersten Schritt des Verfahrens wird der Strom beim Erreichen des jeweiligen Spannungswertes *V*₁, *V*₂ abgeschaltet.

Mit anderen Worten ist die Batteriezelle, wenigstens für einen Zeitbereich, ab den genannten Spannungswerten stromlos. Es wird somit beim Erreichen der Spannungsgrenzen *V*₁ und/oder *V*₂ sozusagen eine stromfreie Pause eingelegt, in welcher kein Strom durch die Batteriezelle fließt. Die Spannung wird jedoch bevorzugt ebenfalls in diesen stromfreien Zeitbereichen weiterhin erfasst beziehungsweise gemessen.

Gemäß einem zweiten Schritt des Verfahrens wird die jeweilige Ruhespannung basierend auf einem durch das Abschalten des Stromes induzierten jeweiligen Abklingverhalten der Spannung ermittelt.

Mit anderen Worten wird der Strom beim Erreichen der Spannungsgrenzwerte *V*₁, *V*₂ abgeschaltet, wodurch jeweils ein Abklingverhalten der Spannung induziert wird. Das jeweilige Abklingverhalten steht in Zusammenhang mit der jeweiligen Ruhespannung. Das ist deshalb der Fall, da bei einem ausreichend langen Abschalten des Stromes, das heißt bei einem ausreichend langen stromlosen Zeitbereich, die Spannung vom jeweiligen Spannungswert *V*₁, *V*₂ auf die jeweilige Ruhespannung abklingen würde. Mit anderen Worten wird die jeweilige Ruhespannung asymptotisch erreicht. Es ist somit vorliegend nicht erforderlich tatsächlich bis zum Erreichen der jeweiligen Ruhespannung abzuwarten, sondern die jeweilige Ruhespannung wird bereits aus dem erfassten Abklingverhalten ermittelt. Ein längeres Abwarten bis zum Erreichen der tatsächlichen Ruhespannungen kann jedoch ebenfalls vorgesehen sein.

Mit anderen Worten baut sich innerhalb der Pause (stromloser Zeitbereich) die Überspannung ab, sodass sich nach genügend langer Wartezeit die Ruhespannung der Batteriezelle einstellen würde. Damit ist die Ruhespannung der individuellen Batteriezelle im aktuellen Zustand genau messbar und es ist nicht erforderlich diese mittels weiteren Messparametern und/oder Modellen abzuschätzen. Dabei ist es erfindungsgemäß bereits ausreichend aus dem Abklingverhalten der jeweiligen Überspannung die jeweilige Ruhespannung zu ermitteln. Ein Abwarten bis die Überspannung nahezu vollständig abgeklungen ist, ist somit erfindungsgemäß nicht erforderlich.

In einem dritten Schritt des Verfahrens erfolgt das Regeln der Spannungswerte *V*₁, *V₂.* Hierbei wird der jeweilige Betrag des Spannungsunterschieds Δ*V*₁*,* Δ*V*₂ zwischen der jeweiligen ermittelten Ruhespannung und ihrem zugehörigen Sollwert *V*ₘᵢₙ, *V*ₘₐₓ als Regeldifferenz verwendet.

Für den oberen Spannungswert *V*₁ bedeutet dies, dass der Betrag der Spannungsdifferenz Δ*V*₁ zwischen der aus dem Abklingverhalten ermittelten Ruhespannung und dem Sollwert *V*ₘₐₓ als Regeldifferenz für die Regelung des Spannungswertes *V*₁ herangezogen wird.

Für den unteren Spannungswert *V*₂ bedeutet dies in analogerweise, dass der Betrag der Spannungsdifferenz Δ*V*₂ zwischen der aus dem Abklingverhalten ermittelten Ruhespannung und dem Sollwert *V*ₘᵢₙ als Regeldifferenz für die Regelung des Spannungswertes *V*₂ herangezogen wird.

Im Rahmen der Regelung wird die jeweilige Regeldifferenz möglichst minimiert. Mit anderen Worten ist der zu erreichender optimaler Zustand durch Δ*V*₁ = 0 beziehungsweise Δ*V*₂ = 0 gekennzeichnet. In diesem Zustand stimmt die jeweilige ermittelte Ruhespannung mit den jeweiligen Sollwerten der Ruhespannung Sollwert *V*ₘᵢₙ, *V*ₘₐₓ im Wesentlichen überein. Mit anderen Worten werden gemäß der Regelung die Spannungswerten *V*₁, *V*₂ derart geregelt, dass die zum jeweiligen Sollwert zugehörige Überspannung erreicht wird. In diesem Sinne werden die zu den Sollwerten der Ruhespannungen zugehörigen Überspannungen durch die Regelung möglichst genau ermittelt und eingestellt.

Mit anderen Worten werden die Spannungsunterschiede Δ*V*₁*,* Δ*V*₂ zur Justierung beziehungsweise als Regelgröße für das HPC- Verfahren verwendet, um bei den folgenden Zyklen genauere Überspannungen einzustellen und den jeweiligen Fehler Δ*V*₁*,* Δ*V*₂ somit möglichst zu minimieren.

Bekannte HPC-Verfahren setzen voraus, dass der Innenwiderstand beziehungsweise die Überspannung hinreichend genau und stets aktuell über vorhandene Modelle in Kombination mit im Test verfügbaren Messdaten bestimmt werden kann. Allerdings können zum einen Messungenauigkeiten von elektrischen und thermischen Parametern die Bestimmung des Innenwiderstands verfälschen. Zum anderen können Schwankungen der Zellqualität und eine Alterung der Batteriezelle die für die Berechnung angenommen Widerstandsmodelle abändern und damit indirekt zu falschen Widerstandswerten führen.

Kommt es zu Schwankungen von Δ*V*₁, Δ*V*₂ im Verlaufe der Testzyklen aufgrund der genannten Fehler, dann weisen die Ladezustände an den Grenzen des Testzyklus keinen festen Bezug mehr zueinander auf. Dadurch ist jedoch die Grundvoraussetzung zur Auswertung der Ladungsmengen im Rahmen bekannter HPC-Verfahren verletzt. Das erfindungsgemäße Verfahren ermöglichen jedoch weiterhin ein genaues und konsistentes Verfahren.

Das ist deshalb der Fall, da das erfindungsgemäße Verfahren die Ruhespannung, bei dem insbesondere eine Ruhephase ohne Stromzufuhr verwendet wird, die Ruhespannung zum jeweils aktuellen Zeitpunkt und individuell für die jeweils verwendete Batteriezelle ermittelt. Daher ist dieses Verfahren von den zuvor beschriebenen Fehlereinflüssen unabhängig und es sind zudem keine Modelle des jeweiligen Batteriezelletyps erforderlich.

Weiterhin ermöglicht das erfindungsgemäße Verfahren eine Regelung der HPC-Methode im laufenden Testbetrieb. Zudem kann ein vorab festgelegter Arbeitspunkt genauer, und individuell für die getestete Zelle und die verwendeten Betriebsbedingungen, eingestellt werden.

Bei dem erfindungsgemäßen HPC-Verfahren für eine Batteriezelle wird wenigstens eine Lebensdauer der Batteriezelle ermittelt. Das erfindungsgemäße Verfahren ist gekennzeichnet dadurch, dass das HPC-Verfahren durch ein Verfahren gemäß der vorliegenden Erfindung und/oder einer ihrer Ausgestaltungen geregelt wird.

Es ergeben sich zum erfindungsgemäßen Regelungsverfahren gleichartige, gleichwertige und gleichwirkende Vorteile und/oder Ausgestaltungen des erfindungsgemäßen HPC-Verfahrens.

Gemäß einer vorteilhaften Ausgestaltung der Erfindung werden für die Regelung die Spannungswerte gemäß *V*₁ = *V*ₘₐₓ + *G*₁*, V*₂ = *V*ₘᵢₙ - *G*₂ modelliert, wobei *G*₁, *G*₂ als Führungsgrößen der Regelung verwendet werden.

Dadurch kann vorteilhafterweise eine Asymmetrie zwischen den Überspannungen beim Laden beziehungsweise Entladen innerhalb der Zyklen berücksichtigt werden.

Sind zu den Sollwerten der Ruhespannungen *V*ₘₐₓ, *V*ₘᵢₙ die Überspannungen *η*₁, *η*₂ zugehörig, so entspricht Δ*V*₁ = 0 beziehungsweise Δ*V*₂ = 0 dem Fall, dass die jeweilige Führungsgröße mit der jeweiligen Überspannung übereinstimmt.

In einer vorteilhaften Weiterbildung der Erfindung berücksichtigt die Regelung weiterhin eine Temperatur und/oder einer Stromstärke.

Mit anderen Worten berücksichtigt die Regelung, dass sich Temperatur und/oder Stromstärke zeitlich ändern können. Hierbei kann bereits vorab der eigentlichen Regelung ein Einstellen eines neues Arbeitspunktes, beispielsweise bei einer Änderung der Temperatur, der Stromstärke und/oder der Sollwerte der Ruhespannung, durchgeführt werden. Hierbei können die initialen Spannungswerte vorab berechnet werden und als Ausgangspunkt für die erfindungsgemäße Regelung verwendet werden.

Gemäß einer besonders bevorzugten Ausgestaltung der Erfindung wird das Abschalten des Stromes nicht durchgeführt, wenn die Regeldifferenz unterhalb eines festgelegten Schwellenwertes ist.

Dadurch kann vorteilhafterweise die Testzeit verkürzt werden, da im genannten Fall weniger stromfreie Zeitbereiche erforderlich sind. Mit anderem Worten kann in dem Fall, dass die Regeldifferenz unterhalb des Schwellenwertes liegt, auf ein Erfassen der Ruhespannung verzichtet werden, da diese bereits ausreichend genau mit ihrem jeweiligen Sollwert übereinstimmt.

In einer vorteilhaften Weiterbildung der Erfindung werden die Ruhespannungen jeweils mittels eines Fit des Abklingverhaltens ermittelt.

Mit anderen Worten wird der Verlauf der Spannung nach dem Abschalten des Stromes wenigstens in einem festgelegten Zeitbereich erfasst und mittels einer Fitfunktion gefittet. Aus dem Fit kann die Ruhespannung ermittelt werden, ohne dass diese tatsächlich in der Messung erreicht wurde. Mit anderen Worten ist vorteilhafterweise das Abklingverhalten bereits ausreichend, den asymptotischen Wert der Ruhespannung mittels des Fits (Kurvenanpassung) zu ermitteln. Dadurch ist ein zu langes Abwarten vorteilhafterweise nicht erforderlich, sodass der Zeitbereich der stromlosen Phase möglichst klein festgelegt werden kann. Insbesondere wird der Strom beziehungsweise die Stromstärke für 1 bis 60 Sekunden, 1 bis 30 Sekunden oder 1 bis 10 Sekunden abgeschaltet.

Gemäß einer vorteilhaften Ausgestaltung der Erfindung wird *F*(*V,λ*|*t*) = V_{OCV} + (*v* - *V*_{OCV})exp (-*λt*) als Fitfunktion verwendet, wobei *V*_{OCV} die jeweilige zu ermittelnde Ruhespannung bezeichnet und *v*, *λ* weitere Fitparameter sind.

Dadurch wird vorteilhafterweise eine besonders genaue Ermittlung der tatsächlichen beziehungsweise der zu ermittelnden Ruhespannung *V*_{OCV} ermöglicht.

In einer vorteilhaften Weiterbildung der Erfindung wird der Strom über einen Zeitbereich von 1 bis 60 Sekunden, 1 bis 30 Sekunden oder 1 bis 10 Sekunden abgeschaltet.

Die genannten Zeitbereiche sind deshalb von Vorteil, da innerhalb dieser ein ausreichend genauer Fit des Abklingverhaltens erreicht werden kann und weiterhin ein zu langes Abwarten verhindert wird. Dadurch wird das Verfahren, insbesondere ein HPC-Verfahren, nicht unnötig zeitlich verlängert, sondern ein synergetisches Optimum zwischen Genauigkeit und Zeitdauer erreicht.

Weiterhin ist es vorteilhaft den stromlosen Zeitbereich beziehungsweise seine Dauer in Abhängigkeit einer Abklingkonstante des Abklingverhaltens festzulegen. Wird beispielsweise die Fitfunktion *F*(*V*,*λ*|*t*) = *V*_{OCV} + (*v* - V_{OCV})exp (-*λt*) verwendet, so entspricht der Fitparameter *λ* der genannten Abklingkonstanten. Die Abklingkonstante entspricht einer charakteristischen Abklingzeit 1/*λ*. Es ist somit vorteilhaft, den stromlosen Zeitbereich beziehungsweise seine Dauer in Abhängigkeit von 1/*λ* festzulegen.

Gemäß einer vorteilhaften Ausgestaltung der Erfindung ist die Batteriezelle als Lithium-Ionen-Batteriezelle ausgebildet.

Das erfindungsgemäße Verfahren ist für Lithium-Ionen-Batteriezellen deshalb von Vorteil, da diese typischerweise eine vorteilhaften Abklingverhalten aufweisen.

In einer vorteilhaften Weiterbildung der Erfindung wird weiterhin eine Selbstentladung der Batteriezelle im Rahmen des HPC-Verfahrens ermittelt.

Vorteilhafterweise kann dadurch die Selbstentladung der Batteriezelle genauer ermittelt werden. Hierbei kann die Selbstentladung mittels der Dauer eines oder mehrerer Zyklen und des jeweiligen gemäß im Rahmen des HPC-Verfahrens ermittelten Ladungsdurchsatzes ermittelt werden.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: ein Ablaufdiagramm eines Verfahrens gemäß einer Ausgestaltung der Erfindung; und
- Figur 2: ein Spannungs-Zeit-Diagramm;

Gleichartige, gleichwertige oder gleichwirkende Elemente können in einer der Figuren oder in den Figuren mit denselben Bezugszeichen versehen sein.

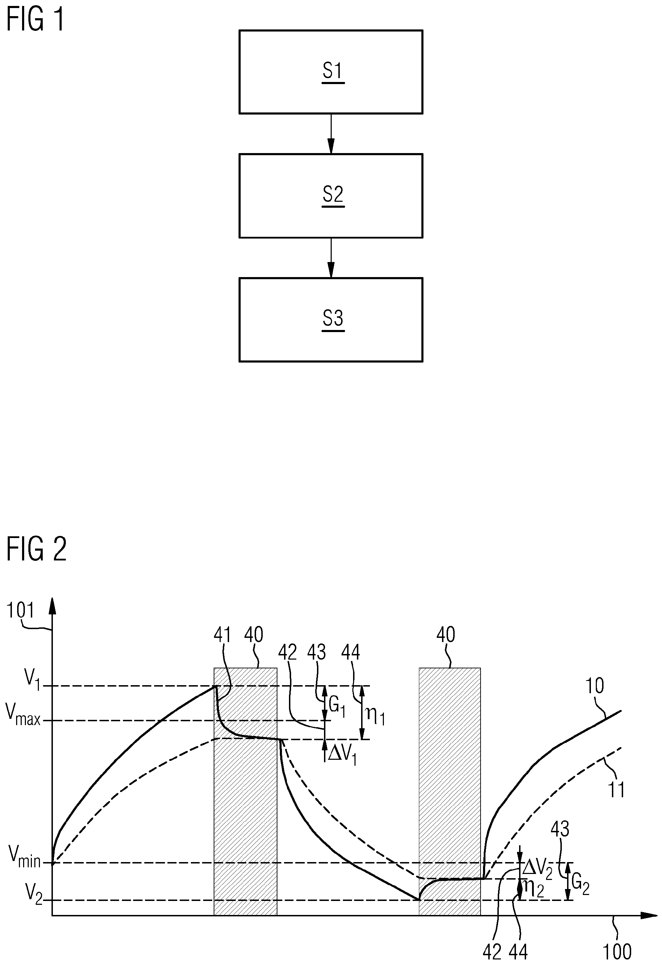

Die Figur 1 zeigt ein Ablaufdiagramm zur Regelung eines HPC-Verfahrens für eine Batteriezelle gemäß einer Ausgestaltung der vorliegenden Erfindung.

Im Rahmen eines HPC-Verfahrens wird ein Ladungsdurchsatz mehrfach hintereinander innerhalb von zeitlichen Zyklen ermittelt. Mit anderen Worten wird die Batteriezelle zwischen zwei regelbaren Spannungswerten *V*₁, *V*₂ zyklisiert. Für das Beladen beziehungsweise Entladen der Batteriezelle werden für jeden Zyklus zugehörige Spannungswerte *V*₁, *V*₂ eingestellt beziehungsweise geregelt. Beispielsweise wird die Batteriezelle bis zum ersten Spannungswert *V*₁ geladen und/oder bis zum zweiten Spannungswert *V*₂ entladen. Die Differenz der zu den Spannungswerten *V*₁, *V*₂ zugehörigen Ladungen bildet den jeweiligen erfassten Ladungsdurchsatz Δ*Q* aus. Aus den erfassten Ladungsdurchsätzen beziehungsweise Ladungsmengen kann die Lebensdauer und/oder die Selbstentladungsrate der Batteriezelle ermittelt werden.

Weiterhin sind für die Regelung zwei Sollwerte der Ruhespannung *V*ₘᵢₙ, *V*ₘₐₓ der Batteriezelle festgelegt.

Gemäß einem ersten Schritt S1 des Verfahrens wird der Strom beziehungsweise die Stromstärke bei einem Erreichen des jeweiligen Spannungswertes *V*₁, *V*₂ abgeschaltet. Hierbei wird der Strom für einen festgelegten Zeitbereich abgeschaltet, beispielsweise für 1 bis 60 Sekunden, insbesondere für 1 bis 30 Sekunden. Diese Pausen bezüglich der Stromstärke sind in der folgenden Figur 2 durch das Bezugszeichen 40 symbolisiert. Mit anderen Worten wird die Batteriezelle so lange geladen, bis der erste Spannungswert *V*₁ erreicht ist. Hierzu kann die Spannung in diskreten zeitlichen Abständen, quasi kontinuierlich und/oder kontinuierlich erfasst werden. Durch das Abschalten des Stromes beziehungsweise der Stromstärke in den Zeitbereichen 40 wird ein Abklingverhalten 41 der Spannung induziert. Mit anderen Worten verringert sich dadurch die Spannung asymptotisch auf die zum Ladezustand zugehörige Ruhespannung der Batteriezelle.

In einem zweiten Schritt S2 des Verfahrens wird somit die jeweilige Ruhespannung basierend auf dem durch das Abschalten des Stromes induzierten jeweiligen Abklingverhalten 41 der Spannung ermittelt. Hierzu ist es nicht erforderlich bis zum Erreichen der Ruhespannung abzuwarten, sondern diese kann durch einen Fit bereits aus dem Abklingverhalten 41 ermittelt werden. Dadurch kann der stromfreie Zeitbereich 40 möglichst kurz sein beziehungsweise verkürzt werden. Der Unterschied zwischen den Spannungswerten und den jeweiligen Ruhespannungen bildet die sogenannte jeweilige Überspannung aus. Die jeweiligen Überspannungen sind in der Figur 2 mit dem Symbol *η*₁ beziehungsweise *η*₂ gekennzeichnet.

Weiterhin bilden sich Spannungsunterschiede Δ*V*₁*,* Δ*V*₂ zwischen den festgelegten Ruhespannungen *V*ₘₐₓ beziehungsweise *V*ₘᵢₙ und den tatsächlichen ermittelten Ruhespannungen *V*_{OCV,max}, *V*_{OCV,min} aus, die mittels des Abklingverhaltens 41 ermittelt wurden. Mit anderen Worten ist *V*_{OCV,min} = *V*ₘᵢₙ - Δ*V*₂ und *V*_{OCV,max} = *V*ₘₐₓ - Δ*V*₁.

Gemäß einem dritten Schritt S3 des Verfahrens werden die Spannungswerte *V*₁, *V*₂ geregelt. Hierbei wird der jeweilige Betrag des Spannungsunterschieds Δ*V*₁*,* Δ*V*₂ 42 zwischen der jeweiligen ermittelten Ruhespannung und ihrem zugehörigen Sollwert *V*ₘᵢₙ, *V*ₘₐₓ als Regeldifferenz für die Regelung verwendet. Mit anderen Worten werden *G*₁, *G*₂ als Führungsgröße für die Regelung verwendet. Diese Führungsgrößen sind in der Figur 2 mit dem Bezugszeichen 43 gekennzeichnet.

Durch das Verwenden der Spannungsunterschiede Δ*V*₁*,* Δ*V*₂ 42 als Regeldifferenz werden diese im Rahmen der Regelung möglichst minimiert. Dadurch werden die Führungsgrößen *G*₁, *G*₂ derart eingeregelt, dass diese den zu den Sollwerten Vₘₐₓ, *V*ₘᵢₙ jeweils zugehörigen Überspannungen entsprechen. Mit anderen Worten werden dadurch die Überspannungen derart eingestellt, dass die jeweiligen Sollwerte für die Ruhespannung im Wesentlichen erreicht werden.

In der Figur 2 ist das bereits unter Figur 1 beschriebene Verfahren mittels eines Spannung-ZeitDiagramms symbolisch dargestellt.

An der Abszisse 100 des Diagramms ist die Zeit in beliebigen Einheiten aufgetragen. An der Ordinate 101 des Diagramms ist die Spannung, die erfasst wird, in beliebigen Einheiten aufgetragen.

Weiterhin ist in der Figur 2 die erfasste Spannung in Form eines Spannungsverlaufes 10 dargestellt. Entsprechend ist die tatsächliche Ruhespannung der Batteriezelle ebenfalls als zeitlicher Ruhespannungsverlauf 11 (gestrichelte Linie) dargestellt.

Die Batteriezelle wird zunächst bis zu einem regelbaren Spannungswert beziehungsweise einer regelbaren Spannungsgrenze *V*₁ geladen. Anschließend wird der Strom beziehungsweise die Stromstärke innerhalb des Zeitbereiches 40 abgeschaltet, wodurch die Spannung ein Abklingverhalten 41 aufweist. Allerdings stimmt aufgrund einer Überspannung *η*₁ die Spannung *V*₁ nicht mit der Ruhespannung der Batteriezelle überein. Mit anderen Worten bildet sich zwischen der festgelegten Ruhespannung *V*ₘₐₓ und der tatsächlichen Ruhespannung ein Spannungsunterschied Δ*V*₁ aus. Analog bildet sich beim Entladen der Batteriezelle aufgrund einer Überspannung *η*₂ ein Spannungsunterschied Δ*V*₂ zwischen der festgelegten Ruhespannung *V*ₘᵢₙ und der tatsächlichen Ruhespannung aus. Die Spannungsunterschiede Δ*V*₁*,* Δ*V*₂ sind in der Figur 2 mit dem Bezugszeichen 42 gekennzeichnet. Die Überspannungen *η₁, η*₂ sind in der Figur 2 mit dem Bezugszeichen 44 gekennzeichnet.

Aus der Figur 2 wird deutlich, dass im dargestellten Beispiel die erreichte Überspannung *η*₁ 44 noch zu gering ist, sodass der erste Sollwert der Ruhespannung *V*ₘₐₓ noch nicht erreicht wurde. Es liegt somit der Spannungsunterschied Δ*V*₁ 42 vor. In analogerweise ist die Überspannung *η*₂ 44 noch zu gering, da ebenfalls der zweite Sollwert der Ruhespannung *V*ₘᵢₙ noch nicht erreicht wurde. Es liegt somit der Spannungsunterschied Δ*V*₂ 42 vor.

Gemäß der Regelung werden die Beträge der Spannungsunterschiede Δ*V*₁ beziehungsweise Δ*V*₂ 42 als Regeldifferenz verwendet. Dadurch regelt die Regelung die Überspannungen 43 derart ein, dass die jeweiligen Sollwerte der Ruhespannungen *V*ₘₐₓ sowie *V*ₘᵢₙ erreicht werden, das heißt, dass die mittels des jeweiligen Abklingverhaltens erfasste Ruhespannung im Wesentlichen mit *V*ₘₐₓ beziehungsweise *V*ₘᵢₙ übereinstimmt. Dadurch wird vorteilhafterweise das HPC-Verfahren mit jedem Zyklus genauer auf die Sollwerte der Ruhespannung eingeregelt. Eine ausreichende Genauigkeit ist beispielsweise erreicht, wenn die Regeldifferenz unterhalb eines festgelegten Schwellenwertes liegt. Ist der genannte Schwellenwert nach einem Zyklus erreicht, so kann besonders bevorzugt für den darauffolgenden Zyklus auf einen stromlosen Zeitbereich 40 verzichtet werden. Dadurch kann die Testzeit verkürzt werden, ohne die Genauigkeit des Verfahrens zu verringern.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- S1: erster Schritt
- S2: zweiter Schritt
- S3: dritter Schritt

- 10: Spannungsverlauf
- 11: Ruhespannungsverlauf
- 12: Ruhespannungskennline
- 40: Abschalten des Stromes
- 41: Abklingverhalten
- 42: Spannungsunterschiede
- 43: Führungsgröße
- 44: Überspannung

- 100: Abszisse
- 101: Ordinate

## Patentansprüche

1. Verfahren zur Regelung eines HPC-Verfahrens für eine Batteriezelle, beim dem die Batteriezelle zwischen zwei regelbaren Spannungswerten *V*₁, *V*₂ zyklisiert wird, wobei für die Regelung zwei Sollwerte der Ruhespannung *V*ₘᵢₙ, *V*ₘₐₓ der Batteriezelle festgelegt sind, **gekennzeichnet durch** folgende Schritte:
- (S1) Abschalten des Stromes bei einem Erreichen des jeweiligen Spannungswertes *V*₁, *V*₂;
- (S2) Ermitteln der jeweiligen Ruhespannung basierend auf einem durch das Abschalten des Stromes induzierten jeweiligen Abklingverhalten (41) der Spannung; und
- (S3) Regeln der Spannungswerte *V*₁, *V*₂, wobei der jeweilige Betrag des Spannungsunterschieds Δ*V*₁*,* Δ*V*₂ (42) zwischen der jeweiligen ermittelten Ruhespannung und ihrem zugehörigen Sollwert *V*ₘᵢₙ, *V*ₘₐₓ als Regeldifferenz verwendet wird.

2. Verfahren gemäß Anspruch 1, **gekennzeichnet dadurch, dass** für die Regelung die Spannungswerte gemäß *V*₁ = *V*ₘₐₓ + *G*₁, *V*₂ = *V*ₘᵢₙ - *G*₂ modelliert werden, wobei *G*₁, *G*₂ als Führungsgrößen (43) der Regelung verwendet werden.

3. Verfahren gemäß Anspruch 1 oder 2, **gekennzeichnet dadurch, dass** die Regelung weiterhin eine Temperatur und/oder einer Stromstärke berücksichtigt.

4. Verfahren gemäß einem der vorhergehenden Ansprüche, **gekennzeichnet dadurch, dass** das Abschalten des Stromes nicht durchgeführt wird, wenn die Regeldifferenz unterhalb eines festgelegten Schwellenwertes ist.

5. Verfahren gemäß einem der vorhergehenden Ansprüche, **gekennzeichnet dadurch, dass** die Ruhespannungen jeweils mittels eines Fit des Abklingverhaltens (41) ermittelt werden.

6. Verfahren gemäß Anspruch 5, **gekennzeichnet dadurch, dass** *F*(*V,λ*/*t*) = V_{OCV} + (*v* - V_{OCV})exp (-*λt*) als Fitfunktion verwendet wird, wobei *V*_{OCV} die jeweilige zu ermittelnde Ruhespannung bezeichnet und *v*, *λ* weitere Fitparameter sind.

7. Verfahren gemäß einem der vorhergehenden Ansprüche, **gekennzeichnet dadurch, dass** der Strom über einen Zeitbereich von 1 bis 60 Sekunden, 1 bis 30 Sekunden oder 1 bis 10 Sekunden abgeschaltet wird.

8. Verfahren gemäß einem der vorhergehenden Ansprüche, **gekennzeichnet dadurch, dass** die Batteriezelle als Lithium-Ionen-Batteriezelle ausgebildet ist.

9. HPC-Verfahren für eine Batteriezelle, bei dem wenigstens eine Lebensdauer der Batteriezelle ermittelt wird, **gekennzeichnet dadurch, dass** das HPC-Verfahren durch ein Verfahren gemäß einem der vorhergehenden Ansprüche geregelt wird.

10. HPC-Verfahren gemäß Anspruch 9, **gekennzeichnet dadurch, dass** weiterhin eine Selbstentladung der Batteriezelle ermittelt wird.
